(19) **Europäisches Patentamt / European Patent Office / Office européen des brevets**

(11) **EP 4 198 526 B1**

(12) **FASCICULE DE BREVET EUROPEEN**

(45) Date de publication et mention de la délivrance du brevet:
**20.08.2025 Bulletin 2025/34**

(51) Classification Internationale des Brevets (IPC):
**G01R 19/25** *(2006.01)*   **G01R 21/06** *(2006.01)*
**G01R 21/133** *(2006.01)*

(21) Numéro de dépôt: **22213206.0**

(52) Classification Coopérative des Brevets (CPC):
**G01R 19/2513; G01R 21/06; G01R 21/1331**

(22) Date de dépôt: **13.12.2022**

(54) **PROCÉDÉS ET SYSTÈMES POUR DÉTERMINER UNE GRANDEUR ÉLECTRIQUE DANS UNE INSTALLATION ÉLECTRIQUE**

VERFAHREN UND SYSTEME ZUR BESTIMMUNG EINER ELEKTRISCHEN GRÖSSE IN EINER ELEKTRISCHEN ANLAGE

METHODS AND SYSTEMS FOR DETERMINING AN ELECTRICAL QUANTITY IN AN ELECTRICAL FACILITY

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **14.12.2021 FR 2113473**

(43) Date de publication de la demande:
**21.06.2023 Bulletin 2023/25**

(73) Titulaire: **SCHNEIDER ELECTRIC INDUSTRIES SAS**
**92500 Rueil-Malmaison (FR)**

(72) Inventeurs:
• **TRIOMPHE, Stéphane**
  **38400 Saint-Martin-d'Hères (FR)**
• **DU PELOUX DE SAINT ROMAIN, Bertrand**
  **38570 THEYS (FR)**
• **BOHRER, Roland**
  **38134 LA SURE EN CHARTREUSE (FR)**

(74) Mandataire: **Lavoix**
**62, rue de Bonnel**
**69448 Lyon Cedex 03 (FR)**

(56) Documents cités:
**EP-A1- 3 761 046    US-A1- 2021 356 501**

**Description**

L'invention se rapporte à un procédé pour déterminer une grandeur électrique dans une installation électrique et à un système correspondant.

L'invention se rapporte plus particulièrement à des capteurs communicants installés au sein d'installations électriques, telles que des réseaux de distribution d'électricité.

On connaît par exemple des capteurs sans fil capables de mesurer des grandeurs électriques, telles que la tension électrique ou le courant électrique.

Les grandeurs électriques mesurées par les capteurs peuvent être utilisées pour contrôler et superviser l'installation électrique, mais aussi pour déterminer d'autres grandeurs électriques qui peuvent être calculées à partir des grandeurs électriques mesurées.

Par exemple, une valeur de puissance électrique ou une valeur de déphasage peuvent être calculées à partir des valeurs de courant et de tension mesurées par les capteurs.

Les mesures sont réalisées par les capteurs de façon répétée, par échantillonnages successifs au cours du temps. Dans de nombreuses applications, il est nécessaire de savoir précisément à quel moment une grandeur électrique a été mesurée par un capteur, par exemple lorsque des données provenant de plusieurs capteurs différents sont combinées entre elles.

Un problème couramment rencontré dans de tels réseaux de capteurs est que les capteurs ne sont pas toujours correctement synchronisés. Bien que chaque capteur soit généralement équipé d'une horloge interne, il est fréquent que ces horloges subissent une dérive au cours du temps, entraînant une perte de la synchronisation entre les capteurs.

Il existe des systèmes dans lesquels un signal de synchronisation est envoyé par un capteur principal à destination des autres capteurs, afin que ces capteurs puissent recaler leur horloge sur un signal d'horloge de référence.

Les demandes de brevet EP 3 761 046 A1 et US 2021/356501 A1 concernent des systèmes de calcul de puissance distribués.

La demande de brevet US 2017/08379 A1 décrit un exemple de synchronisation, qui a cependant pour inconvénient de nécessiter une liaison câblée entre les capteurs. Une telle solution n'est pas applicable à des réseaux de capteurs sans fil.

De plus, dans le cas de capteurs sans fil, l'envoi répété d'un message de synchronisation peut encombrer le réseau utilisé par les capteurs pour communiquer entre eux. En effet, il est fréquent que ces capteurs soient connectés entre eux par des moyens de communication radio à bas débit et à basse portée.

En outre, les composants électroniques utilisés par les capteurs pour traiter les données introduisent un temps de traitement qui peut varier d'un capteur à l'autre. Cela peut entraîner des erreurs, qui sont variables d'un capteur à l'autre.

Au final, les capteurs sont difficiles à synchroniser, et il est difficile de savoir avec certitude si les valeurs censées avoir été mesurées à un même instant par tous les capteurs ont réellement été mesurées simultanément. Lorsque les données mesurées sont utilisées pour calculer d'autres grandeurs électriques, comme la puissance électrique, il existe un risque que le calcul soit faussé par cette perte de synchronisation.

Il est donc souhaitable de pouvoir déterminer des grandeurs électriques, notamment des grandeurs électriques calculées à partir de mesures réalisées par les capteurs, de façon simple et fiable.

A cet effet, un aspect de l'invention concerne un procédé pour déterminer une grandeur électrique dans une installation électrique selon la revendication 1.

Grâce à l'invention, en horodatant les mesures de courant et de tension et en tenant compte du retard intrinsèque propre à la chaîne de mesure de chaque capteur, il est possible de compenser les éventuels retards après que la mesure a été faite.

Plus particulièrement, au lieu de chercher à synchroniser les capteurs de courant et de tension pour qu'ils mesurent les signaux en même temps, ce sont les signaux de tension et de courant mesurés par les capteurs qui sont virtuellement synchronisés.

Selon des aspects avantageux mais non obligatoires, un tel procédé peut incorporer une ou plusieurs des caractéristiques des revendications dépendantes 2 à 12.

Selon un autre aspect, l'invention concerne un système pour déterminer une grandeur électrique dans une installation électrique selon la revendication 13.

L'invention sera mieux comprise et d'autres avantages de celle-ci apparaîtront plus clairement à la lumière de la description qui va suivre d'un mode de réalisation d'un procédé et d'un système pour déterminer une grandeur électrique dans une installation électrique, donnée uniquement à titre d'exemple et faite en référence aux dessins annexés, dans lesquels :

[Fig 1] la figure 1 est une illustration schématique d'un système de mesure de grandeurs électriques selon un mode de mise en œuvre de l'invention, ce système comprenant au moins un module de mesure de tension et une pluralité de module de mesure de courant ;

[Fig 2] la figure 2 illustre schématiquement des étapes mises en œuvre par le module de mesure de tension de la figure 1 ;

[Fig 3] la figure 3 est une illustration schématique d'un procédé de synchronisation mis en œuvre par les module de mesure du système de la figure 1 pour déterminer une grandeur électrique ;

[Fig 4] la figure 4 illustre schématiquement des étapes mises en œuvre par chaque module de mesure de courant de la figure 1 ;

[Fig 5] la figure 5 est une illustration schématique illustrant un retard pour chaque mesure dans les capteurs de courant et de tension du système de la figure 1 ;

[Fig 6] la figure 6 est une illustration schématique d'un procédé de calibration mis en œuvre par les capteurs de courant du système de la figure 1.

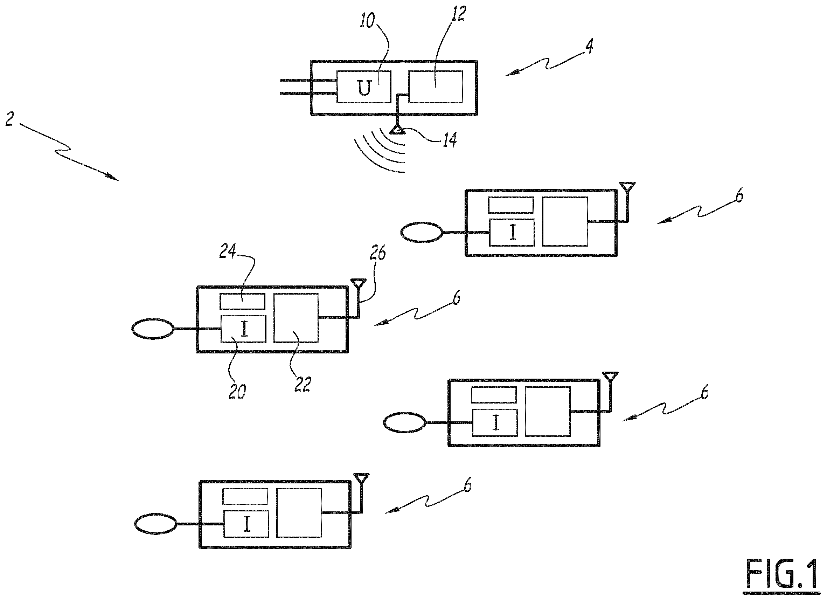

La figure 1 représente schématiquement un système de mesure 2 pour mesurer des grandeurs électriques.

Le système 2 est destiné à être associé à une installation électrique, telle qu'une installation de distribution d'électricité, pour mesurer des grandeurs électriques au sein de cette installation électrique. De préférence, les grandeurs électriques mesurées comportent au moins le courant électrique et la tension électrique.

Le système 2 est également configuré pour déterminer au moins une grandeur électrique à partir des grandeurs mesurées.

Par exemple, ladite grandeur électrique calculée est une puissance électrique (notamment une puissance électrique moyenne, ou une puissance électrique instantanée, ou autre) calculée à partir de valeurs de courant électrique et de tension électrique mesurée par les capteurs. En variante, il pourrait s'agir d'une puissance réactive, ou d'un déphasage, ou d'un facteur de puissance de l'installation électrique, ou d'une valeur énergie, ou de toute autre grandeur électrique utile.

Le système 2 comporte au moins un module de mesure de tension 4 et au moins un module de mesure de courant 6.

En pratique, le système 2 comporte de préférence une pluralité de modules de mesure de courant 6.

Par exemple, les modules de mesure 4 et 6 sont répartis dans l'installation électrique.

Dans certaines variantes, le système 2 pourrait comporter plusieurs modules de mesure de tension 4 mais dans ce cas ces modules fonctionneront de préférence de façon indépendante les uns des autres, de sorte que la description qui sera faite ci-après pourra être transposée à ces modes de réalisation.

De préférence, les modules de mesure 4 et 6 sont des capteurs connectés (ou capteurs communicants) qui embarquent des moyens de traitement d'information et des moyens de communications. Les modules de mesure 4 et 6 peuvent ainsi former un réseau de capteurs.

Chaque module de mesure comporte un élément de mesure, aussi nommé senseur, ou « capteur » à proprement parler.

Par exemple, pour le module de mesure de tension 4 est destiné à mesurer une tension électrique, l'élément de mesure est un capteur de tension 10 (noté « U » sur la figure), par exemple un pont diviseur, ou un transformateur de tension, ou un capteur capacitif, ou tout autre capteur approprié. Pour le module de mesure de courant 6, l'élément de mesure est un capteur de courant 20 (noté « I » sur la figure), tel qu'un tore de Rogowski, ou un transformateur de courant, ou un capteur à effet Hall, ou un capteur de mesure par dérivation, aussi nommé « shunt », ou tout autre élément équivalent.

En outre, chaque module de mesure 4, 6 comporte un circuit électronique de traitement comportant un processeur, une mémoire, une horloge et une interface de communication.

Chaque module de mesure 4, 6 comporte de préférence un boîtier dans lequel sont logés tout ou partie des constituants dudit module de mesure. Les modules de mesure 4, 6 peuvent aussi optionnellement comporter tout moyen nécessaire à leur fonctionnement, tel qu'une alimentation électrique ou une batterie.

Lorsque le système 2 est opérationnel, les modules de mesure 4 et 6 sont couplés à l'installation. Par exemple, les éléments de mesure respectifs des modules 4, 6 sont associés à des conducteurs électriques de l'installation électrique. L'installation électrique n'est pas représentée sur la figure 1 dans un souci de lisibilité des dessins.

Les capteurs 4 et 6 peuvent être répartis dans l'installation à des emplacements différents. Par exemple, dans de nombreux modes de réalisation, les capteurs de courant sont associés à des branches de l'installation formées par des conducteurs électriques, et le capteur de tension est placé en amont des capteurs de courant. En pratique, de préférence, les branches de l'installation sur lesquelles sont installées les capteurs de courant partagent la même source de tension.

Selon un exemple illustratif et non limitatif, l'installation électrique comporte une ligne électrique primaire et plusieurs lignes électriques secondaires qui sont dérivées de la première ligne électrique. La ligne primaire est par exemple raccordée à une source électrique, telle qu'un générateur ou un transformateur de distribution, ou à un autre réseau électrique. Chaque ligne secondaire raccorde la ligne primaire à une entité cliente, comportant par exemple une charge électrique. Les modules 4, 6 sont alors associés à des conducteurs électriques de l'installation électrique, par exemple montés sur ou autour des conducteurs électriques formant les lignes principale et secondaires, pour mesurer une ou plusieurs grandeurs électriques relatives à ces lignes électriques. Notamment, dans le cas d'une installation polyphasée, notamment triphasée, alors chaque ligne électrique primaire ou secondaire peut comporter plusieurs conducteurs de phase, chacun associé à une phase électrique ou éventuellement à une ligne de neutre. De préférence, chaque module de mesure 4, 6 est alors configuré pour mesurer individuellement les valeurs de courant et de tension associées à chacune des phases sur cette ligne électrique.

D'autres configurations sont toutefois possibles.

Dans de nombreux modes de réalisation, dans chaque module de mesure 4 et 6, le circuit de traitement de données est implémenté par un ou plusieurs circuits électroniques.

Le processeur de chaque module de mesure 4 et 6 est un microprocesseur ou un microcontrôleur programmable. Le processeur est couplé à une mémoire informatique, ou à tout support d'enregistrement de données lisible par ordinateur, qui comporte des instructions exécutables et/ou un code logiciel prévu pour mettre en œuvre, entre autres, un procédé pour déterminer une ou plusieurs grandeurs électriques lorsque ces instructions sont exécutées par le processeur.

L'emploi du terme « processeur » dans cette description ne fait pas obstacle à ce qu'en variante, au moins une partie des fonctions de chaque module de mesure 4, 6 soit réalisée par d'autres composants électroniques, tels qu'un processeur de traitement du signal (DSP), ou un composant logique reprogrammable (FPGA), ou un circuit intégré spécialisé (ASIC), ou tout élément équivalent, ou toute combinaison de ces éléments.

Le circuit électronique de traitement de chaque module de mesure 4, 6 peut également comporter des composants permettant de mettre en forme et/ou de filtrer les signaux mesurés par l'élément de mesure avant leur traitement par le processeur, comme un convertisseur analogique-numérique (ADC).

L'horloge de chaque module de mesure 4, 6 comporte un oscillateur électronique, par exemple un oscillateur à cristal, tel qu'un oscillateur à quartz. Par exemple, l'horloge peut être intégrée au processeur dudit module de mesure 4, 6.

L'interface de communication de chaque module de mesure 4, 6 permet d'échanger des données avec d'autres modules de mesure 4, 6 et/ou avec un ou plusieurs autres éléments, tel qu'un concentrateur de données ou des équipements de télécommunications, ou des équipements informatiques.

Dans des modes de réalisation préférés, l'interface de communication est une interface sans fil, permettant d'établir une liaison de communication sans fil, par exemple une liaison radio. Par exemple, la liaison radio peut être une liaison radio à courte portée, telle qu'une liaison Bluetooth Low Energy (marque déposée) ou équivalent. En variante, il peut s'agir d'une liaison radio à bas débit et à longue portée, telle qu'une liaison Zigbee (marque déposé), ou équivalent.

Dans d'autres modes de réalisation, l'interface de communication est configurée pour établir une liaison de communication filaire, par exemple au moyen d'un ou de plusieurs câbles, tels que des câbles Ethernet ou autre. La liaison filaire peut, par exemple, être un bus de données.

Dans l'exemple illustré, le circuit de traitement et l'interface de communication du premier module de mesure 4 portent respectivement les références « 12 » et « 14 ». Le circuit de traitement, la mémoire et l'interface de communication du deuxième module de mesure 6 portent respectivement les références numériques « 22 », « 24 » et « 26 ».

De façon générale, chaque module de mesure 4, 6 est configuré pour mesurer une grandeur électrique telle que la tension ou le courant de façon répétée au cours du temps, par exemple en échantillonnant (mesurant) cette grandeur électrique périodiquement avec une fréquence d'échantillonnage fixée.

En pratique, la tension électrique et le courant électrique peuvent être des grandeurs alternatives qui évoluent périodiquement au cours du temps, par exemple avec une forme sinusoïdale.

Par exemple, le module de mesure de tension 4 mesure périodiquement une tension électrique avec une première fréquence d'échantillonnage. Chaque module de mesure de courant 6 mesure périodiquement un courant électrique avec une deuxième fréquence d'échantillonnage. La première fréquence d'échantillonnage et la deuxième fréquence d'échantillonnage sont supérieures à la fréquence du signal mesuré.

Dans de nombreux exemples, la première fréquence d'échantillonnage est choisie égale à la deuxième fréquence d'échantillonnage. Mais cela n'est pas indispensable et, en variante, la première fréquence d'échantillonnage pourrait être différente de la deuxième fréquence d'échantillonnage.

Le système 2 est notamment configuré pour déterminer au moins une grandeur électrique, telle qu'une puissance électrique, à partir du courant et de la tension mesurés par les différents modules de mesure 4, 6. Par exemple, on peut calculer la puissance électrique (par exemple une valeur instantanée ou une valeur moyenne) pour différentes branches de l'installation électrique.

Ce calcul est réalisé à partir des valeurs de courant et de tension échantillonnées au cours du temps. Par exemple, pour chaque instant, une valeur de ladite grandeur (telle que la puissance) est calculée à partir des valeurs de courant et de tension échantillonnées pour cet instant.

Pour ce calcul, il est souhaitable que les valeurs de courant et de tension utilisées pour calculer une telle grandeur électrique pour chaque instant donné correspondent à des instants simultanés ou quasi-simultanés.

Par exemple, dans cette description, par « quasi simultanément », on entend que les mesures sont réalisées pour un même instant à 0,1 microsecondes (μs) près.

Avantageusement, le procédé pourrait être généralisé à tout mécanisme de synchronisation et d'ajustement temporel d'horloge realisé par échange de messages entre les modules de mesure 4 et 6 pour horodater les échantillons, qui satisfasse l'exigence de précision de la mesure.

En pratique, le calcul de ladite grandeur (telle que la puissance) est réalisé par un processeur, par exemple par un des modules de mesure de courant, ou par un équipement informatique dédié qui est en communication avec les modules de mesure 4, 6.

De façon générale, le système 2 est configuré (et programmé) pour mettre en œuvre un procédé comportant des étapes consistant à :

par le module de mesure de tension 4 :

mesurer périodiquement une tension électrique (U) dans l'installation électrique,
envoyer périodiquement à au moins un des modules de mesure de courant 6 un signal de synchronisation (Top signal),
envoyer audit module(s) de mesure de courant 6 un message comportant une donnée d'horodatage principale (TopMasterTime) indiquant l'instant auquel le module de mesure de tension a émis le signal de synchronisation, cet instant étant mesuré par le module de mesure de tension avec son horloge,
envoyer audit module(s) de mesure de courant 6 un message comportant au moins une valeur de tension mesurée,

par module de mesure de courant 6 :

mesurer périodiquement un courant électrique dans l'installation électrique,
à la réception du signal de synchronisation envoyé par le module de mesure de tension 4, calculer, au moyen de l'horloge dudit module de mesure de courant 6, une donnée d'horodatage locale (TopLocalTime) indiquant l'instant auquel le module de mesure de courant 6 a reçu ledit signal de synchronisation,
déterminer des valeurs de correction de retard successives à partir de la donnée d'horodatage principale reçue (TopMasterTime) et la donnée d'horodatage locale calculée pour chaque signal de synchronisation reçu du module de mesure de tension, les mesures de courant successives réalisées par le module de mesure de courant étant horodatées par le module de mesure de courant 6, au moyen de son horloge, en tenant compte des valeurs de correction de retard ainsi déterminées.

Puis, par un processeur, calculer au moins une valeur d'une grandeur électrique à partir des valeurs de courant et de tension successives issues des modules de mesure.

Les valeurs de courant et de tension mesurées indépendamment par les modules de mesure de tension 4 et de courant 6 ne sont pas synchrones, car les horloges respectives de ces modules sont indépendantes.

Toutefois, comme on le verra ci-après, l'étape de calcul fait intervenir une correction qui permet de resynchroniser a posteriori les valeurs mesurées de courant avec les valeurs mesurées de tension, notamment en vue de réaligner les valeurs de courant (qui sont mesurées à des instants discrets) sur une même échelle de temps que les valeurs de tension mesurées.

Par exemple, on interpole les valeurs de courant manquantes pour les instants où les valeurs de tension ont été mesurées, afin de rééchantillonner des valeurs de courant entre des données mesurées. Les valeurs de courant et de tension apparaissent alors avoir été mesurées simultanément, ce qui permet de calculer ladite grandeur électrique avec une bonne précision. Autrement dit, des valeurs de courant sont calculées par interpolation entre les valeurs réellement mesurés (échantillonnées), pour obtenir des valeurs de courant synchrones avec les valeurs de tension issues du module de mesure de tension 6.

Avantageusement, comme expliqué plus en détail dans la description qui va suivre, des données d'horodatage des valeurs de tension sont mesurées par le module de tension, à partir de l'horloge du module de tension.

Les données d'horodatage en tension correspondent à l'instant ou la mesure de tension a été effectué, ou à un instant proche avec un décalage le plus stable possible dans le temps. Chaque données d'horodatage est de préférence envoyée par le module de mesure de tension avec la valeur mesurée de tension.

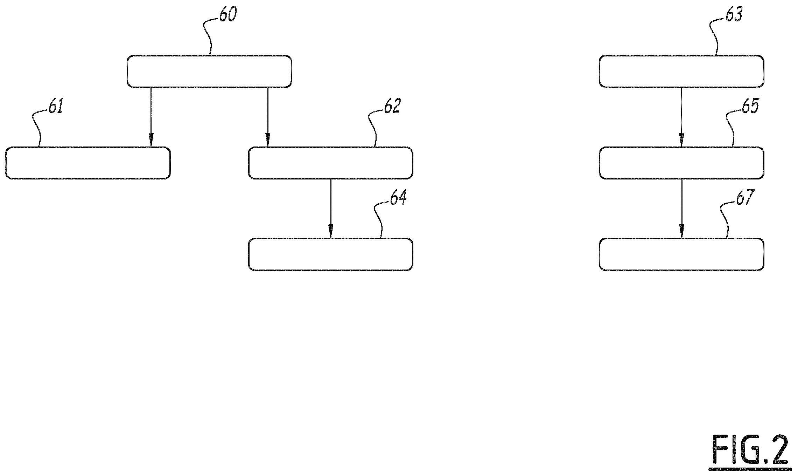

Un exemple d'un procédé de fonctionnement du système 2 est maintenant décrit en référence aux figures 2, 3 et 4. En variante, les étapes du procédé qui va être décrit pourraient être exécutées dans un ordre différent. Certaines étapes pourraient être omises. L'exemple décrit ne fait pas obstacle à ce que, dans d'autres modes de réalisation, d'autres étapes soient mises en œuvre conjointement et/ou séquentiellement avec les étapes décrites.

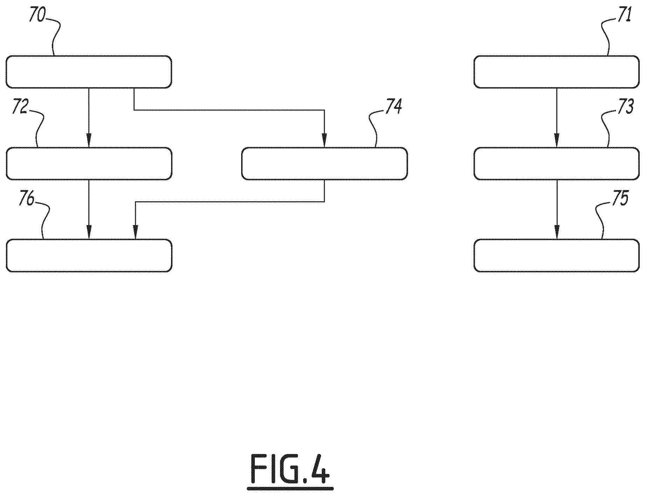

Le schéma de la figure 2 représente les étapes mises en œuvre par au moins un module de mesure de tension 4. Le schéma de la figure 4 représente les étapes mises en œuvre par un module de mesure de tension 6.

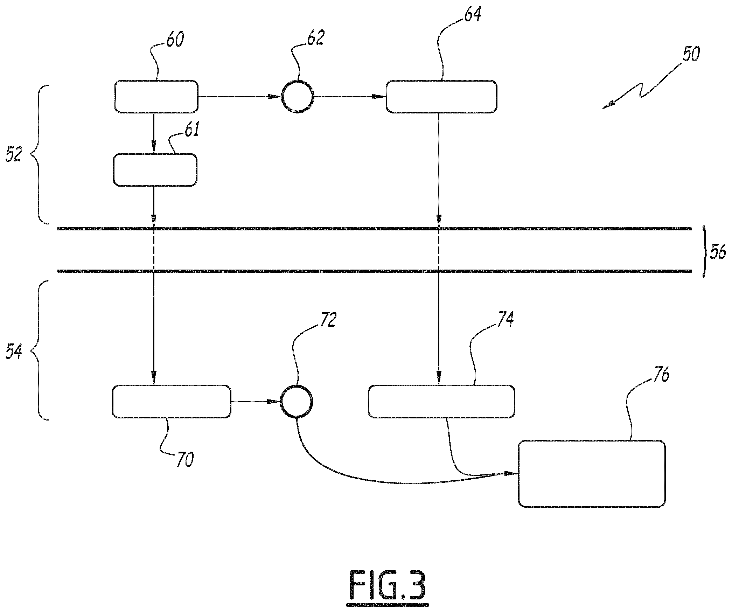

Le schéma 50 de la figure 3 représente à la fois des étapes mises en œuvre par au moins un module de mesure de tension 4 (référence 52) et par un des modules de mesure de courant 6 (référence 54).

Les étapes illustrées sur ces figures sont, par exemple, mises en œuvre par les processeurs respectifs du module de mesure de tension 4 et des modules de mesure de courant 6.

Le procédé est décrit pour un des modules de mesure de courant 6, mais on comprend qu'en pratique chacun des modules de mesure de courant 6 met en œuvre des étapes analogues, indépendamment des autres modules de mesure de courant 6.

Le module de mesure de tension 4 et chacun des modules de mesure de courant 6 sont en communication au moyen de liaisons de communications 56 pouvant former un réseau de communications. Cette communication est permise par les interfaces de communication 14 et 26 précédemment décrites.

Initialement, le module de mesure de tension 4 et chacun des modules de mesure de courant 6 sont installés dans l'installation électrique.

En pratique, les étapes du procédé sont répétées périodiquement pendant une phase de fonctionnement du système 2. Toutefois, pour simplifier la description, seule une itération de ces étapes est décrite en détail.

De plus, sur le schéma de la figure 3, seules les étapes relatives à la gestion du temps et de la synchronisation sont explicitées en détail, les étapes relatives aux mesures de courant et de tension n'étant pas explicitées en détail sur cette figure.

Le procédé débute à l'étape 60, dans laquelle le module de mesure de tension 4 émet un signal de synchronisation. Par exemple, ce signal de synchronisation marque le début d'un cycle répété périodiquement.

Le signal de synchronisation est envoyé sur la liaison de communication 56 (étape 61). En pratique, c'est l'envoi de ce message sur la liaison de communication qui tient lieu de signal de synchronisation. Dans ce cas les étapes 60 et 61 sont combinées.

Le module de mesure 4 effectue ensuite, à l'étape 62, un horodatage (« time stamp » en anglais) au moyen de son horloge. Ce faisant, le module de mesure 4 détermine une donnée d'horodatage, dite « donnée d'horodatage principale » pour dater, dans le référentiel de temps du module de mesure 4, l'instant (Top time) auquel le signal de synchronisation est émis.

Dans cette description, le terme horodatage est utilisé pour désigner une opération consistant à mesurer à quel instant survient un évènement vu par le module de mesure au moyen de son horloge, puis pour associer à l'évènement en question cet instant mesuré.

Par exemple, les données d'horodatage (les valeurs des instants mesurés) sont associées aux valeurs mesurées en étant stockées en mémoire dans une liste, ou un tableau, ou dans toute structure de données appropriée.

En d'autres termes, la donnée d'horodatage principale indique l'instant auquel le module de mesure de tension émet le signal de synchronisation, cet instant étant mesuré par le module de mesure de tension avec son horloge, dans son référentiel de temps.

Ensuite, le module de mesure 4 envoie, à au moins un des modules de mesure de courant 6, un message comportant la donnée d'horodatage principale (étape 64).

En parallèle, lors d'une étape 63, le module de mesure de tension 4 mesure une tension électrique dans l'installation électrique, de préférence de façon périodique avec la première fréquence d'échantillonnage. Par exemple, module de mesure de tension 4 échantillonne la tension avec son capteur de tension 10.

Ce faisant, lors d'une étape 65, le module de mesure 4 détermine une donnée d'horodatage pour chaque mesure de tension (pour chaque échantillonnage) pour dater l'instant de la mesure de tension dans le référentiel de temps du module de mesure de tension 4. En d'autres termes, chaque valeur de tension mesurée est horodatée par le module de mesure 4 avec son horloge.

Ensuite, le module de mesure 4 envoie, à chacun des modules de mesure de courant 6 correspondants un message comportant la valeur de tension mesurée (étape 67), de préférence avec son horodatage.

En pratique, dans un mode de réalisation préféré, le module de mesure de tension 4 l'envoi du signal de synchronisation, de la donnée d'horodatage principale et des valeurs de tension mesurées est groupé un même message. Autrement dit, les étapes 61, 64 et 67 sont combinées.

Par exemple, ce message tient lieu de signal de synchronisation et comporte, enregistrées dans le corps du message, les valeurs de tension mesurées et la donnée d'horodatage principale associée au précédent signal de synchronisation (c'est-à-dire celui ayant initié le cycle précédent).

Toutefois, dans d'autres modes de réalisation, le module de mesure de tension 4 pourrait envoyer le signal de synchronisation, la donnée d'horodatage principale et les valeurs de tension mesurées dans des messages séparés.

Dans d'autres modes de réalisation, les messages pourraient être partiellement combinés, par exemple comme sur la figure 3, avec lors de chaque cycle, un premier message pour le signal de synchronisation et un deuxième message pour envoyer le reste des données.

Dans de nombreux modes de réalisation, la fréquence d'envoi du message peut être inférieure à la première fréquence d'échantillonnage et à la deuxième fréquence d'échantillonnage. Par exemple, la fréquence d'envoi du message est au moins dix fois inférieure à la première fréquence d'échantillonnage et/ou à la deuxième fréquence d'échantillonnage. A titre d'exemple, chaque message envoyé par le module de mesure de tension 4 comporte un nombre d'échantillons (de valeurs de mesures) de tension compris entre vingt et cent, voire entre trente et cinquante. Dans le cas où le module de mesure est associé à plusieurs conducteurs électriques et comporte autant de capteurs de tension, par exemple dans une installation polyphasée, alors chaque message envoyé peut comporter les valeurs mesurées pour ces différents conducteurs au même instant.

Dans ce qui suit, le module de mesure de tension 4 pourra être nommé « module principal ».

De plus, comme on le verra après, les données d'horodatage principal contenues dans les messages envoyés par le module de mesure de tension 4 sont utilisées par la suite pour compenser les variations de retard et les dérives en temps entre les différents modules de mesure 4 et 6.

Lors d'une étape 70, le module de mesure de courant 6 reçoit le signal de synchronisation envoyé par le module de mesure de tension 4. Par exemple, cela correspond à la réception d'un message sur l'interface de communication 56.

En pratique, le signal de synchronisation est détectable par tous les modules de mesure de courant 6. La détection pourra se faire avec plus ou moins de retard par les différents modules de mesure de courant 6, à condition que ce retard soit fixe pour chaque mesure.

A la réception du signal de synchronisation envoyé par le module de mesure de tension 4, le module de mesure de courant 6 mesure (étape 72), au moyen de son horloge, une donnée d'horodatage locale indiquant l'instant auquel le module de mesure de courant 6 a reçu ledit signal de synchronisation.

Selon les modes de réalisation possibles, on peut prendre comme instant de détection de réception du signal de synchronisation le moment à partir duquel le préambule du message est reçu par l'interface de communication 56, ou le moment à partir duquel le corps du message est reçu. D'autres exemples sont possibles en variante, du moment que la méthode utilisée est consistante et qu'elle engendre le moins de variabilité possible dans la durée de traitement à la réception du message entre des cycles de mesure successifs.

De préférence encore, pour limiter une telle variabilité, le message est envoyé par le module de mesure de tension 4 en limitant voire en omettant toute communication bidirectionnelle entre les interfaces de communication respectives 14 et 26 des modules de mesure 4 et 6 (par exemple en omettant des routines de communication bidirectionnelle de type « handshake » ou de type « discovery »).

De préférence, ledit message est envoyé par un procédé de diffusion (« broadcast » en anglais) par le module de mesure de tension 4.

De préférence encore, ledit message a un en-tête de longueur fixe.

Ensuite, lors d'une étape 74, les données d'horodatage principales (précédemment générées par le module 4) contenues dans le message reçu sont extraites. La donnée d'horodatage principale reçue du capteur de tension 4 et étant associée à l'envoi du signal de synchronisation est par exemple associée à la donnée d'horodatage locale calculée lors de la réception du signal de synchronisation.

A l'étape 76, le module de mesure de courant 6 détermine automatiquement des paramètres qui permettront d'estimer le décalage en temps entre l'horloge locale du module de mesure de courant 6 et l'horloge du module de mesure de tension 4. Autrement dit, le module de mesure de courant 6 détermine des paramètres visant à exprimer le temps mesuré localement par son horloge dans le référentiel de temps correspondant au module de mesure de tension 4.

Cela permet notamment de calculer la dérive en temps du module de mesure 6 par rapport au module de mesure 4.

Cela permet surtout au module de mesure de courant 6 d'estimer le référentiel de temps du module principal 4 et de convertir l'horodatage des mesures de courant dans ce référentiel estimé. Néanmoins, l'estimation de la synchronisation des échantillons en courant et en tension comporte une erreur, qui ne sera connue ou corrigée que lorsque le procédé de calibration décrit ci-après aura été mis en œuvre.

Dans de nombreux modes de réalisation, un décalage (offset) entre les modules 4 et 6 est calculé à partir de la différence entre les instants d'envoi du message. Une dérive en temps (« drift » en anglais) du module de mesure de courant 6 est estimée à partir du rapport entre l'intervalle de temps entre deux envois consécutifs du message par le module de mesure de tension 4 tel que déterminé à partir des données d'horodatage principales, et l'intervalle de temps entre la réception de deux messages consécutifs par le module de mesure de courant 6.

Dans certains exemples, pour chaque module de mesure de courant 6, la durée entre deux messages consécutifs reçus peut être décomptée et utilisée comme information pour déterminer cette correction. Cela permet de dater l'instant de réception dudit message dans le référentiel de temps du module de mesure de courant 6.

De façon générale, la correction de retard appliquée sur les données d'horodatage associées aux valeurs de courant mesurées est calculée en fonction de la différence entre la donnée d'horodatage principale reçue et la donnée d'horodatage locale calculée pour un même signal de synchronisation.

Par exemple, le module de mesure 6 calcule le coefficient de dérive en temps (noté « Slope ») au moyen de la formule suivante :

[Math 1]

$$Slope = \frac{MasterTimeBetweenTops}{LocalTimeBetweenTops}$$

où : « MasterTimeBetweenTops » désigne l'intervalle de temps entre deux envois consécutifs du signal de synchronisation par le module de mesure de tension 4, cet intervalle de temps étant déterminé à partir des données d'horodatage principales contenues dans les messages envoyés successivement, et où

« LocalTimeBetweenTops » désigne l'intervalle de temps entre la réception de deux signaux de synchronisation consécutifs par le module de mesure 6.

De préférence, le coefficient utilisé pour les calculs ultérieurs est déterminé en calculant une moyenne sur plusieurs cycles (par exemple en prenant la moyenne courante calculée à partir d'au moins dix ou cinquante valeurs précédentes).

D'autres méthodes de calcul sont néanmoins possibles en variante.

Par exemple, le module de mesure 6 calcule l'écart (noté « Offset ») entre le démarrage des horloges respectives des deux modules de mesure 4 et 6 au moyen de la formule suivante :

[Math 2]

$$Offset = LastSyncMasterTime$$

où « LastSyncMasterTime » désigne l'instant d'envoi du message par le module de mesure de tension 4 (nommé « Top time » dans ce qui précède), cet instant étant mesuré (horodaté) par le module de mesure de tension 4 dans son référentiel de temps, cette information étant contenue dans le message reçu.

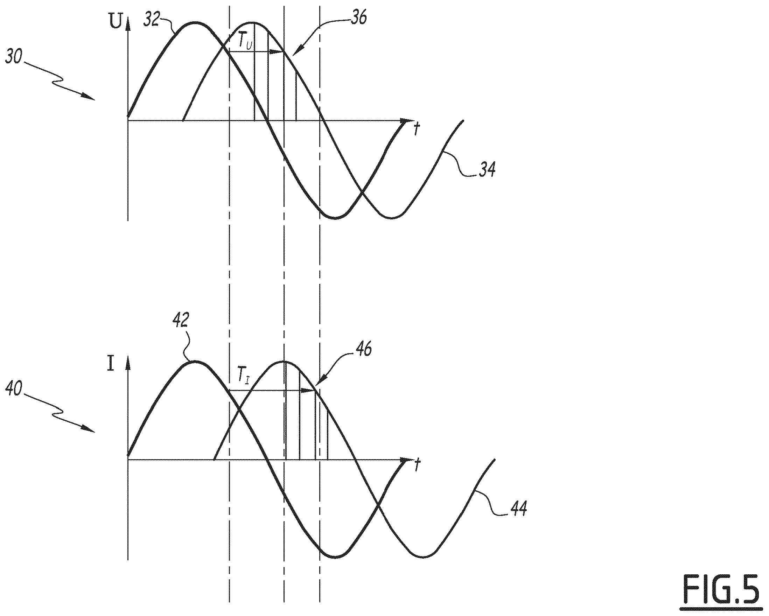

Sur la figure 5, cet écart n'est pas visible et a déjà été corrigé, les deux courbes ayant la même ligne de temps.

Ces valeurs de dérive en temps et d'écart sont calculées lors de l'étape 76, qui est préférentiellement répétée périodiquement.

En parallèle de ces étapes, lors d'une étape 71, le module de mesure de courant 6 mesure (échantillonne) la valeur de courant. Cette mesure est par exemple répétée plusieurs fois de façon périodique, par exemple avec la deuxième fréquence d'échantillonnage.

Chaque mesure de courant est ensuite horodatée lors d'une étape 73 par le module de mesure de courant 6 avec son horloge locale, en tenant compte des valeurs de correction déterminées lors de l'étape 76. Les valeurs mesurées et les données d'horodatage correspondantes peuvent ensuite être enregistrées lors d'une étape 75.

En d'autres termes, à chaque fois que le module 6 échantillonne une valeur de courant électrique avec l'élément de mesure 20, le module de mesure 6 détermine une donnée d'horodatage locale correspondante pour chaque mesure de courant (pour chaque échantillonnage), cet horodatage étant réalisé en tenant compte des valeurs de correction déterminées lors de l'étape 76. Cela permet de dater l'instant de la mesure de courant dans un référentiel de temps corrigé qui correspond au référentiel de temps du module principal 4 (ou du moins qui s'en rapproche le plus possible), et dans lequel le décalage en temps entre les module 4 et 6 est automatiquement compensé.

De préférence, l'horodatage corrigé est réalisé en calculant un temps estimé (noté « EstimatedMasterTime ») au moyen de la formule suivante :

[Math 3]

$$EstimatedMasterTime(LocalTime)$$
$$= Offset + Slope \times (LocalTime - LastSyncLocalTime)$$

où :

« Offset » et « Slope » sont les valeurs de correction calculées précédemment à l'étape 76, « LocalTime » désigne la valeur d'horodatage local non corrigée (c'est-à-dire l'instant mesuré au moyen de l'horloge locale, à l'instar de ce qui est fait lors de l'étape 70) et « LastSyncLocalTime » désigne l'instant de réception du message par le module de mesure de courant 6, cet instant étant mesuré (horodaté) par le module de mesure de courant 6 dans son référentiel de temps.

D'autres formules de calcul peuvent être utilisées.

Par exemple, le calcul du temps estimé est répété pour, les mesures de courant successives réalisées étant alors horodatées avec ce temps estimé, jusqu'à la mise à jour suivante. En variante, le temps estimé peut être recalculé pour chaque mesure de courant.

Un avantage de ces modes de réalisation est que, comme les valeurs de correction sont calculées périodiquement, alors les horodatages locaux réalisés pour les mesures de courant sont mis à jour périodiquement, par exemple lors de chaque cycle, ce qui permet de compenser automatiquement les éventuelles dérives en temps qui pourraient survenir au cours du fonctionnement de chaque module de mesure de courant 6, telle qu'une dérive d'horloge.

En variante, chaque mesure de courant pourrait être horodatée lors de l'étape 73 par le module de mesure de courant 6 avec son horloge locale, comme décrit précédemment. Ensuite, la donnée d'horodatage corrigée pourrait être calculée séparément, dans un second temps, pour chaque mesure de courant, à partir de la donnée d'horodatage locale et en tenant compte des valeurs de correction déterminées lors de l'étape 76.

En parallèle de ces étapes basées sur des horodatages, dans de nombreux modes de réalisation, le procédé met avantageusement en œuvre des étapes de correction des valeurs de courant et de tension mesurées en se basant sur des données de calibration déjà connues (par exemple enregistrées en mémoire).

La figure 5 représente un exemple illustrant un aspect de l'échantillonnage des valeurs de courant et de tension par les modules de mesure 4 et 6.

Le graphique 30 comporte une première courbe 32 qui représente l'évolution de la tension réelle (notée U, en ordonnées) dans un emplacement de l'installation électrique au cours du temps (noté t, en abscisses).

La deuxième courbe 34 représente l'évolution de la tension mesurée reconstituée à partir des valeurs échantillonnées par le capteur de tension au cours du temps.

La référence 36 désigne un point de mesure donné à titre d'exemple pour illustrer l'existence d'un retard, noté « $T_U$ » entre le moment où la tension réelle prend une certaine valeur et le moment pour lequel l'échantillonnage correspondant est terminé.

En pratique, ce premier retard $T_U$ correspond à la durée requise par le circuit de traitement 12 pour traiter le signal mesuré par l'élément de mesure 10. Ce retard est généralement fixe pour une fréquence donnée ; il s'agit d'une caractéristique de la chaîne de mesure du module de mesure de tension 4, et dépend par exemple des propriétés de l'élément de mesure 10, du convertisseur analogique-numérique, du processeur présents dans le circuit de traitement 12, et également des filtres numériques implémentés par le processeur, entre autres.

Toujours sur la figure 5, le graphique 40 comporte une première courbe 42 qui représente l'évolution du courant réel (noté I, en ordonnées) dans un emplacement de l'installation électrique au cours du temps (noté t, en abscisses).

La deuxième courbe 44 représente l'évolution du courant mesuré reconstitué à partir des valeurs échantillonnées par le capteur de courant 6 au cours du temps.

La référence 46 désigne un point de mesure donné à titre d'exemple pour illustrer l'existence d'un retard, noté « $T_I$ » entre le moment où le courant « réel » prend une certaine valeur et le moment pour lequel l'échantillonnage correspondant est terminé.

En pratique, ce deuxième retard $T_I$ correspond à la durée requise par le circuit de traitement 22 pour traiter le signal mesuré par l'élément de mesure 20. Ce retard est généralement fixe pour une fréquence donnée ; il s'agit d'une caractéristique de la chaîne de mesure du module de mesure de courant 6, et dépend par exemple des propriétés de l'élément de mesure 20, du convertisseur analogique-numérique et du processeur présents dans le circuit de traitement 22, entre autres.

Un second aspect vise donc à corriger ou compenser au moins er partie ces retards, grâce à une calibration réalisée initialement, notamment pour compenser automatiquement la différence entre le deuxième retard $T_I$ et le premier retard $T_U$.

Par exemple, la compensation en temps vise à compenser des retards fixes présents dans les chaînes de mesure des modules de mesure 4 et 6, et vise surtout à compenser un retard global fixe qui est équivalent à la somme de la différence entre un retard du module de mesure 4 et un retard du module de mesure 6 (ces retards étant intrinsèques à l'électronique de mesure des modules 4 et 6), avec la différence entre le décalage en temps du module de mesure 4 et le décalage en temps du module de mesure 6 (ces décalages étant le résultat du processus décrit à la figure 3, qui génère accidentellement des délais dus à la mise en œuvre des horodatages et/ou des envois de messages).

Par exemple, la compensation en temps (Calibration time) est représentative d'un retard global donné par la formule suivante :

[Math 4]

$$Calibration\ time = Tu - Ti + TimeSyncOffset\_U - TimeSyncOffset\_I$$

où $T_U$ est le retard du module de mesure 4 et $T_I$ est le retard du module de mesure 6 tels que définis en référence à la figure 5 « TimeSyncOffset_U » est le décalage en temps du module de mesure 4 et « TimeSyncOffset_I » est le décalage en temps du module de mesure 6.

Par exemple, la correction en temps est appliquée en augmentant ou en diminuant le temps donné par l'horloge du module 4 ou 6 par la valeur de calibration prédéfinie issue de la calibration.

Cette correction est par exemple réalisée par le module de mesure 4. Toutefois, en variante, cette correction peut être réalisée après l'envoi du message. La correction peut être réalisée de façon centralisée avant le calcul de la grandeur électrique, notamment si ce calcul est réalisé par une entité du système 2 distincte des modules de mesure 4 et 6.

De plus, les valeurs de courant mesurées sont automatiquement corrigées en tenant compte d'une valeur de correction en temps préenregistrée en mémoire, cette valeur de correction en temps étant issue d'un procédé préalable de calibration.

Par exemple, les valeurs de courant mesurées sont ré-échantillonnées pour que les valeurs de courant soient « réalignées » a posteriori sur la même échelle de temps que les valeurs mesurées de tension. Cela permet que, lors d'un calcul ultérieur, les valeurs de tension et de courant apparaissent a posteriori comme ayant été mesurées simultanément ou quasi-simultanément, quand bien même les mesures ont été réalisées par des modules de mesure distincts possédant chacun sa propre horloge, ces horloges n'étant pas activement synchronisées.

En pratique, le nombre d'échantillons de courant peut être modifié pour que leur nombre corresponde au nombre de valeurs de tension contenues dans chaque message.

En pratique, chaque message peut comporter un même nombre de valeurs de tension mesurées pour chaque cycle (par exemple 40 échantillons de tension par message).

Cette correction est par exemple réalisée par le module de mesure 6, mais là encore la correction peut être réalisée différemment, par exemple a posteriori de façon centralisée.

Enfin, à l'issue du procédé, par exemple une fois que les valeurs de tension et de courant ont été acquises par les modules de mesure 4 et 6 (et corrigées au moyen des données de calibration), au moins une valeur de la grandeur électrique (telle que la puissance électrique) est calculée à partir des valeurs de courant et de tension successives issues des modules de mesure 4 et 6. Dans d'autres variantes, le calcul de la grandeur électrique est réalisé en temps réel, au fur et à mesure que les valeurs de courant sont mesurées par les modules de mesure 6 et que les valeurs de tensions mesurées sont reçues par les modules de mesure 6.

Par exemple, pour calculer une puissance électrique, chaque valeur de tension mesurée est multipliée avec la valeur de courant correspondante estimée (par interpolation) au même instant. L'opération est répétée pour calculer et obtenir une succession de valeurs représentant l'évolution de la puissance électrique au cours du temps.

On comprend donc que le calcul de ladite grandeur électrique est réalisé en tenant compte (au moins implicitement) des valeurs de correction de retard calculées pour chaque capteur pour chacune des mesures. Le calcul de ladite grandeur électrique prend également en compte (au moins implicitement) les corrections de calibration apportées aux valeurs de courant et de tension mesurées. Optionnellement, d'autres corrections peuvent être apportées à cette occasion, par exemple pour ajuster la compensation en temps en fonction d'autres paramètres comme la fréquence du signal mesuré.

Grâce à un mode de réalisation de l'invention, en horodatant les mesures de courant et de tension et en tenant compte du retard intrinsèque propre à la chaîne de mesure de chaque capteur, il est possible de corriger le retard après que la mesure a été faite.

En d'autres termes, au lieu de synchroniser les horloges des modules de mesure de courant et de tension pour qu'ils mesurent la tension et le courant en même temps, ce sont les signaux de tension et de courant mesurés par les capteurs qui sont virtuellement synchronisés, en corrigeant le référentiel de temps des modules de mesure du courant.

Il est ainsi possible de déterminer des grandeurs électriques, notamment des grandeurs électriques calculées à partir des mesures réalisées par les modules de mesure, telle qu'une puissance électrique, de façon simple et fiable.

De plus, le fait d'utiliser les valeurs de calibration en courant et en tension permet avantageusement de compenser les retards fixes dus à la chaîne de mesure des différents modules de mesure 4 et 6 (des retards généralement constants dans le temps pour une fréquence donnée, ces retards et/ou ces déphasages provenant d'éléments tels que le convertisseur analogique-numérique, un filtre anti-repliement analogique et les filtres numériques implémentés dans le processeur, par exemple).

Optionnellement, les valeurs de tension mesurées peuvent également être corrigées de façon analogue, par exemple avant leur envoi dans ledit message, en tenant compte d'une valeur de correction en temps préenregistrée en mémoire, cette valeur de correction en temps étant issue d'un procédé préalable de calibration.

Par exemple, les valeurs de tension mesurées lors d'un cycle de mesure sont rééchantillonnées, par exemple pour que chaque cycle de mesure (et le cas échéant chaque message envoyé) comporte un même nombre de valeurs de tension mesurées (par exemple 40 échantillons de tension par cycle de mesure). Lors de ce rééchantillonnage, on utilise une base de temps corrigée qui inclut une compensation en temps issue du procédé de calibration.

Une telle calibration des valeurs de tension reste néanmoins optionnelle et peut être omise. De même que pour la calibration des valeurs de courant, précédemment décrite, on peut ajuster la compensation en temps en fonction de la fréquence du signal mesuré.

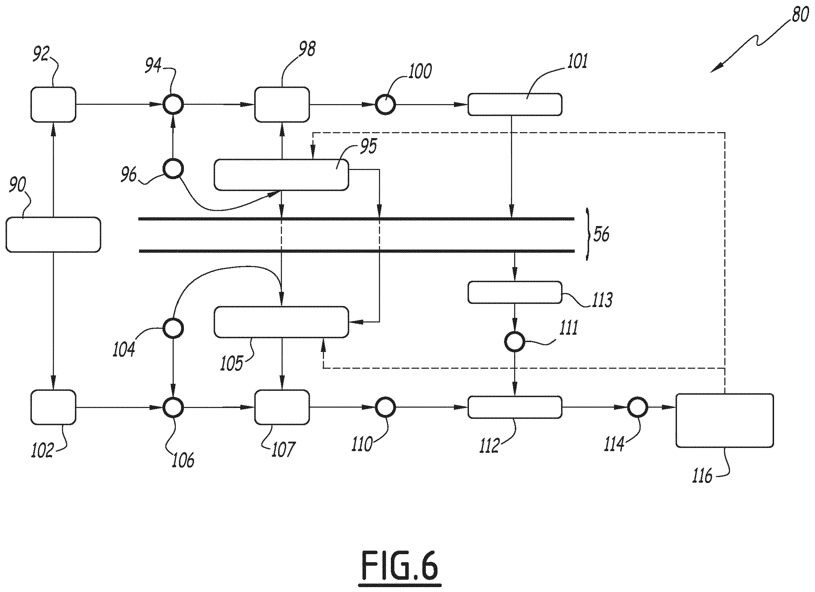

La figure 6 décrit un exemple d'un procédé de calibration mis en œuvre pour calibrer initialement les modules de mesure 4 et 6 du système 2 afin de calculer les valeurs de calibration en courant et en tension utilisées dans le procédé précédemment décrit.

Ce procédé de calibration est ici illustré en conjonction avec les étapes de mesure de tension et de courant précédemment décrites.

Ce procédé de calibration est de préférence réalisé en usine avant la mise en service du système 2. Toutefois, de façon optionnelle mais néanmoins avantageuse, le procédé de calibration peut être mis en œuvre après la mise en service du système 2, par exemple en répétant la calibration à des intervalles réguliers (tous les ans par exemple).

Le schéma 80 de la figure 6 représente des étapes mises en œuvre par au moins un module de mesure de tension 4 (moitié supérieure du schéma) et par un des modules de mesure de courant 6 (moitié inférieure du schéma) lors d'une phase de test distincte de la phase de fonctionnement. Ces étapes sont, par exemple, mises en œuvre par les processeurs respectifs du module de mesure de tension 4 et des modules de mesure de courant 6.

Là encore, les étapes du procédé qui va être décrit pourraient être exécutées dans un ordre différent. Certaines étapes pourraient être omises. L'exemple décrit ne fait pas obstacle à ce que, dans d'autres modes de réalisation, d'autres étapes soient mises en œuvre conjointement et/ou séquentiellement avec les étapes décrites.

La calibration est réalisée en injectant des signaux alternatifs de courant et de tension dont le déphasage est connu. Les signaux peuvent provenir d'un générateur de signal au sein d'une installation de test qui est alimentée par le générateur de signal. Il peut aussi s'agir de signaux réels dans une installation en cours de fonctionnement.

Au bloc 90, les signaux de test sont émis.

Lors d'une étape répétée périodiquement (bloc 92), le module de mesure de tension 4 acquiert une valeur de tension en échantillonnant le signal de test.

Au bloc 94, la valeur de tension mesurée est horodatée avec l'horloge du module 4, par exemple avec une donnée d'horodatage fournie par l'horloge du module 4 (bloc 96).

Au bloc 98, les données d'horodatage associées aux valeurs mesurées de tension sont corrigées avec une donnée de correction fournie par un premier module de synchronisation du module de mesure 4 (bloc 95).

Cela permet de se placer dans un référentiel de temps principal idéal.

Le module de synchronisation est ici configuré pour implémenter les fonctions de gestion de synchronisation décrites en référence aux figures 2, 3 et 4, par exemple pour la gestion des signaux de synchronisation et pour la gestion des paramètres de correction de temps.

Par exemple, le premier module de calibration 95 émet un signal de synchronisation et l'instant correspondant est horodaté grâce à l'horloge du module 4 (bloc 96). La donnée d'horodatage principale correspondante contient à ce stade le retard dit de synchronisation (TimeSyncOffset _U) associé au module 4.

Dans l'exemple illustré, le signal de synchronisation est envoyé sur la liaison de communication 56 à destination du module 6 sous la forme d'un message comportant la donnée d'horodatage principale (ou celle mesurée pour le précédent signal de synchronisation).

La donnée de correction fournie au bloc 98 permet d'horodater les échantillons de tension avec une information d'horodatage corrigée (bloc 100). En pratique, les données d'horodatage corrigées peuvent malgré tout contenir un retard générique attendu pour tous les modules de mesure de tension.

Le bloc 96 correspond ici à l'horloge locale qui fournit les données d'horodatage locales du module 6.

Ces données d'horodatage sont ensuite envoyées au module 6.

Par exemple, au bloc 101, le module 4 envoie un message sur la liaison de communication 56 à destination du module 6, ce message comportant les échantillons de tension horodatés.

En parallèle, pour le module de mesure de courant 6, lors d'une étape répétée périodiquement (bloc 102), le module de mesure 6 acquiert une valeur de courant en échantillonnant le signal de test reçu.

Au bloc 106, la valeur de courant mesurée est horodatée avec l'horloge du module 6, par exemple avec une donnée d'horodatage fournie par l'horloge du module 6 (bloc 104).

Au bloc 107, les données d'horodatage fournies par l'horloge du module 6 sont corrigées avec une donnée de correction fournie par un module de calibration du module de mesure 6 (bloc 105).

Par exemple, le module de calibration 105 initie un cycle dès réception du signal de synchronisation envoyé par le module 4. L'instant correspondant est horodaté grâce à l'horloge du module 6 (bloc 104). La donnée d'horodatage locale correspondante contient à ce stade le retard dit de synchronisation (TimeSyncOffset _I) associé au module 6.

Le module 105 détermine une valeur de temps estimée, à partir de l'horodatage local et de la donnée d'horodatage principale reçue dans le message, de façon analogue à ce qui a été décrit précédemment en référence au procédé de la figure 3.

Cette donnée, fournie au bloc 107, permet d'horodater les échantillons de courant avec une information d'horodatage corrigée (bloc 110) mais celle-ci comporte néanmoins à ce stade le retard $T_I$. Du fait que le temps estimé contient les retards provenant du module de mesure de tension 4 ainsi que les retards introduits par le module 6 lors de l'horodatage, alors les données d'horodatage sont entachées du retard global précédemment défini (Calibration Time). Il est à noter qu'en général, on ne connaitra pas les valeurs absolues de ces retards, mais on s'assurera qu'ils soient identiques dans tous les modules de mesure, et que les différences de temps entre les valeurs de courant et de tension soient nulles.

En parallèle, au bloc 113, le module 6 reçoit les échantillons de tension contenus dans le message reçu. Les données d'horodatage sont extraites (bloc 111) et, au bloc 112, les valeurs mesurées de courant sont rééchantillonnées pour les faire correspondre en temps avec les valeurs mesurées de tension qui ont été reçues du module 4 (c'est-à-dire pour que les valeurs mesurées de courant soient réalignées en temps avec les valeurs de tension). Ensuite, on détermine le déphasage entre le courant et la tension mesurés, et on compare cette phase avec le déphasage connu entre les signaux d'entrée pour déterminer le retard global de la chaîne de mesure. Cela permet de déterminer des données de correction en tension ou en courant (selon qu'un module de mesure de référence en tension ou en courant a été utilisé). Les données de correction sont ensuite fournies (par un module de calcul illustré au bloc 116) au module de calibration 95 et au module de calibration 105. Ce sont également ces données de correction qui sont utilisées dans le procédé de la figure 3.

Par exemple, pour déterminer le déphasage entre les signaux de tension et de courant, au bloc 114, les valeurs de puissance active et de puissance réactive sont calculées à partir des valeurs de tension et de courant mesurées. D'autres méthodes sont néanmoins possibles pour déterminer le déphasage entre les signaux de tension et de courant.

Puis, au bloc 116, une valeur de correction en temps est calculée pour les modules de mesure 4 et 6 à partir des valeurs de puissance active et de puissance réactive calculées.

Par exemple, la valeur de correction en temps (UCalibTimeCorrection) pour le module de mesure en tension 4 est calculée au moyen de la formule suivante :

[Math 5]

$$UCalibTimeCorrection = \frac{Arctan\left(\frac{Q}{P}\right) - CalibrationTarget}{360 \times Frequency}$$

où « Q » et « P » sont, respectivement, la puissance réactive et la puissance active (moyennes) précédemment calculées, « CalibrationTarget » est la valeur du déphasage entre le signal d'entrée de tension et le signal d'entrée de courant et « Frequency » est la fréquence d'oscillation des signaux de tests.

Par exemple, la valeur de correction en temps (ICalibTimeCorrection) pour le module de mesure en tension 4 est calculée de la même façon.

Cette valeur est ensuite fournie aux modules 95 et 105 pour décaler le temps du signal mesuré par au moins l'un des modules 4 et 6 respectifs. Par exemple, le temps donné par l'horloge du module 4 ou 6 est augmentée ou diminuée de cette quantité UCalibTimeCorrection ou ICalibTimeCorrection.

De préférence, les modules de mesure en tension 4 et en courant 6 sont calibrés séparément. Par exemple, lorsque l'on calibre le module de mesure en tension 4, on utilise comme module de mesure de courant 6 un module de mesure de référence, qui bien que possédant un retard intrinsèque, est idéalement dépourvu de retards supplémentaires ou de dérive en temps. Il en va de même lorsque l'on calibre un module de mesure de courant 6, en prenant un module de mesure en tension 4 de référence.

On comprend que, pour calculer la valeur de correction en temps, le procédé de calibration utilise le procédé pour déterminer une grandeur électrique tel que précédemment décrit en référence aux figures 2 à 5 notamment. Cela permet au procédé de calibration de corriger les défauts temporels (notamment la différence en temps) et d'être indépendant de la liaison de communication utilisée.

Optionnellement, le procédé de calibration peut aussi permettre de corriger l'horloge du module 4 qu'elle corresponde ou se rapproche le plus près possible d'une à une horloge idéale. Cela permet d'améliorer la mesure de la fréquence de la tension.

Par exemple, la valeur de calibration de la dérive en temps (CalibrationDrift) est donnée par la formule suivante :

[Math 6]

$$CalibrationDrift = \frac{Frequency - FrequencyTarget}{FrequencyTarget}$$

où « Frequency » est la fréquence d'oscillation des signaux de tests et « FrequencyTarget » est une fréquence cible, par exemple la fréquence des cycles de mesure.

Les modes de réalisation et les variantes envisagés ci-dessus peuvent être combinés entre eux pour donner naissance à de nouveaux modes de réalisation.

**Revendications**

1. Procédé pour déterminer une grandeur électrique dans une installation électrique, au moyen d'un système de mesure (2) comportant au moins un module de mesure de tension (4) et au moins un module de mesure de courant (6) couplés à l'installation électrique, chacun desdits modules de mesure comportant un capteur, un processeur, une mémoire et une horloge, le procédé comportant :

   • par le module de mesure de tension (4) :

   ▪ mesurer périodiquement une tension électrique (U) dans l'installation électrique,
   ▪ envoyer périodiquement à au moins un des modules de mesure de courant un signal de synchronisation,
   ▪ envoyer audit module de mesure de courant un message comportant au moins une donnée d'horodatage principale indiquant l'instant auquel le module de mesure de tension a émis le signal de synchronisation, cet instant étant mesuré par le module de mesure de tension avec son horloge,
   ▪ envoyer audit module de mesure de courant un message comportant au moins une valeur de tension mesurée,

   • par un module de mesure de courant (6) :

   ▪ mesurer périodiquement un courant électrique (I) dans l'installation électrique,
   ▪ à la réception du signal de synchronisation envoyé par le module de mesure de tension, calculer, au moyen de l'horloge dudit module de mesure de courant, une donnée d'horodatage locale indiquant l'instant auquel le module de mesure de courant a reçu ledit signal de synchronisation,
   ▪ déterminer des valeurs de correction de retard successives à partir de la donnée d'horodatage principale reçue et la donnée d'horodatage locale calculée pour chaque signal de synchronisation reçu du module de mesure de tension, les mesures de courant successives réalisées par le module de mesure de courant étant horodatées par le module de mesure de courant, au moyen de son horloge, en tenant compte des valeurs de correction de retard ainsi déterminées,

   • par un processeur, calculer au moins une valeur d'une grandeur électrique à partir des valeurs de courant et de tension successives mesurées par les modules de mesure.

2. Procédé selon la revendication 1, dans lequel la correction de retard appliquée sur les données d'horodatage associées aux valeurs de courant mesurées est calculée en fonction de la différence entre la donnée d'horodatage principale reçue et la donnée d'horodatage locale calculée pour un même signal de synchronisation.

3. Procédé selon l'une quelconque des revendications précédentes, dans lequel le calcul de ladite valeur d'une grandeur électrique comporte au préalable une interpolation des valeurs de courant pour les instants correspondant aux instants pour lesquels les valeurs de tension ont été mesurées par le module de mesure de tension, ladite interpolation étant réalisée à partir des valeurs de courant mesurées et des données d'horodatage associées aux valeurs de courant mesurées.

4. Procédé selon l'une quelconque des revendications précédentes, dans lequel une dérive en temps du module de mesure de courant est estimée par le rapport entre, d'une part, l'intervalle de temps entre deux envois consécutifs du signal de synchronisation par le module de mesure de tension, cet intervalle de temps étant déterminé à partir des données d'horodatage principales, et d'autre part de l'intervalle de temps entre la réception de deux signal de synchronisation reçus consécutivement par le module de mesure de courant, cet intervalle de temps étant déterminé à partir des données d'horodatage locales.

5. Procédé selon l'une quelconque des revendications précédentes, dans lequel chaque mesure de tension par le module de mesure de tension est horodatée par le module de mesure de tension, une donnée d'horodatage correspondante étant envoyée par le module de mesure de tension correspondant, pour chaque valeur de tension mesurée.

6. Procédé selon la revendication 5, dans lequel les données d'horodatage associées aux valeurs de tension mesurées sont automatiquement corrigées, avant leur envoi dans ledit message, en tenant compte d'une valeur de correction en temps préenregistrée en mémoire, cette valeur de correction en temps étant issue d'un procédé préalable de calibration.

**EP 4 198 526 B1**

7. Procédé selon l'une quelconque des revendications 1 à 5, dans lequel des données d'horodatage associées aux valeurs de courant mesurées sont automatiquement corrigées en tenant compte d'une valeur de correction en temps préenregistrée en mémoire, cette valeur de correction en temps étant issue d'un procédé préalable de calibration.

8. Procédé selon la revendication 6 ou la revendication 7, dans laquelle pour calculer la valeur de correction en temps, le procédé de calibration comporte un procédé pour déterminer une grandeur électrique conforme à l'une quelconque des revendications précédentes.

9. Procédé selon l'une quelconque des revendications précédentes, dans lequel les modules de mesure du système sont en communication par l'intermédiaire d'une liaison de communication sans fil, chaque message envoyé par le module de mesure de tension étant un message radio.

10. Procédé selon l'une quelconque des revendications 1 à 8, dans lequel les modules de mesure du système sont en communication par l'intermédiaire d'une liaison de communication filaire, telle qu'un bus de données.

11. Procédé selon l'une quelconque des revendications précédentes, dans lequel le calcul de la valeur d'une grandeur électrique est réalisé par un circuit électronique de traitement d'au moins un des modules de mesure de courant.

12. Procédé selon l'une quelconque des revendications précédentes, dans lequel la valeur d'une grandeur électrique calculée est une puissance électrique calculée à partir des valeurs de courant et de tension mesurées par les modules de mesure.

13. Système (2) pour déterminer une grandeur électrique dans une installatior électrique, ce système comportant au moins un module de mesure de tension (4) et au moins un module de mesure de courant (6) couplés à l'installation électrique, chacun desdits modules de mesure comportant un capteur, un processeur, une mémoire et une horloge, le système étant configuré pour mettre en œuvre un procédé pour déterminer une grandeur électrique, le procédé comportant :

    • par le module de mesure de tension (4) :

        ▪ mesurer périodiquement une tension électrique (U) dans l'installation électrique,
        ▪ envoyer périodiquement à au moins un des modules de mesure de courant un signal de synchronisation
        ▪ envoyer audit module de mesure de courant un message comportant au moins une donnée d'horodatage principale indiquant l'instant auquel le module de mesure de tension a émis le signal de synchronisation, cet instant étant mesuré par le module de mesure de tension avec son horloge,
        ▪ envoyer audit module de mesure de courant un message comportant au moins une valeur de tension mesurée,

    • par un module de mesure de courant (6) :

        ▪ mesurer périodiquement un courant électrique (I) dans l'installation électrique,
        ▪ à la réception du signal de synchronisation envoyé par le module de mesure de tension, calculer, au moyen de l'horloge dudit module de mesure de courant, une donnée d'horodatage locale indiquant l'instant auquel le module de mesure de courant a reçu ledit signal de synchronisation,
        ▪ déterminer des valeurs de correction de retard successives à partir de la donnée d'horodatage principale reçue et la donnée d'horodatage locale calculée pour chaque signal de synchronisation reçu du module de mesure de tension, les mesures de courant successives réalisées par le module de mesure de courant étant horodatées par le module de mesure de courant, au moyen de son horloge, en tenant compte des valeurs de correction de retard ainsi déterminées,

    • par un processeur, calculer au moins une valeur d'une grandeur électrique à partir des valeurs de courant et de tension successives mesurées par les modules de mesure.

**Patentansprüche**

1. Verfahren zum Bestimmen einer elektrischen Größe in einer elektrischen Anlage mittels eines Messsystems (2), umfassend mindestens ein Spannungsmessmodul (4) und mindestens ein Strommessmodul (6), die mit der elektrischen Anlage gekoppelt sind, jedes der Messmodule umfassend einen Sensor, einen Prozessor, einen Speicher und einen Zeitgeber, das Verfahren umfassend:

- durch das Spannungsmessmodul (4):

  ▪ periodisches Messen einer elektrischen Spannung (U) in der elektrischen Anlage,
  ▪ periodisches Senden, an mindestens eines der Strommessmodule, eines Synchronisationssignals,
  ▪ Senden, an das Strommessmodul, einer Nachricht, umfassend mindestens ein Haupt-Zeitstempeldatum, das den Zeitpunkt angibt, an dem das Spannungsmessmodul das Synchronisationssignal emittiert hat, wobei dieser Zeitpunkt von dem Spannungsmessmodul mit seiner Uhr gemessen wird,
  ▪ Senden, an das Strommessmodul, einer Nachricht, umfassend mindestens einen gemessenen Spannungswert,

- durch ein Strommessmodul (6):

  ▪ periodisches Messen eines elektrischen Stroms (I) in der elektrischen Anlage,
  ▪ bei Empfang des von dem Spannungsmessmodul gesendeten Synchronisationssignals, Berechnen, mittels der Zeitgebers des Strommessmoduls, lokaler Zeitstempeldaten, die den Zeitpunkt angeben, an dem das Strommessmodul das Synchronisationssignal empfangen hat,
  ▪ Bestimmen aufeinanderfolgender Verzögerungskorrekturwerte anhand der empfangenen Haupt-Zeitstempeldaten und den lokalen Zeitstempeldaten, die für jedes von dem Spannungsmessmodul empfangene Synchronisationssignal berechnet werden, wobei die von dem Strommessmodul durchgeführten aufeinanderfolgenden Strommessungen von dem Strommessmodul mittels seines Zeitgebers unter Berücksichtigung der somit bestimmten Verzögerungskorrekturwerte mit einem Zeitstempel versehen werden,

- durch einen Prozessor, Berechnen mindestens eines Werts einer elektrischen Größe anhand der aufeinanderfolgenden Strom- und Spannungswerte, die von den Messmodulen gemessen werden.

2. Verfahren nach Anspruch 1, wobei die Verzögerungskorrektur, die auf die mit den gemessenen Stromwerten assoziierten Zeitstempeldaten angewendet wird, abhängig von der Differenz zwischen den empfangenen Haupt-Zeitstempeldaten und den berechneten lokalen Zeitstempeldaten für ein und dasselbe Synchronisationssignal berechnet wird.

3. Verfahren nach einem der vorherigen Ansprüche, wobei die Berechnung des Werts einer elektrischen Größe zuvor eine Interpolation der Stromwerte für die Zeitpunkte umfasst, die den Zeitpunkten entsprechen, für die die Spannungswerte von dem Spannungsmessmodul gemessen wurden, wobei die Interpolation anhand der gemessenen Stromwerte und der mit den gemessenen Stromwerten assoziierten Zeitstempeldaten durchgeführt wird.

4. Verfahren nach einem der vorherigen Ansprüche, wobei eine Zeitverschiebung des Strommessmoduls durch das Verhältnis zwischen einerseits dem Zeitintervall zwischen zwei aufeinanderfolgenden Sendungen des Synchronisationssignals durch das Spannungsmessmodul, wobei dieses Zeitintervall aus den Haupt-Zeitstempeldaten bestimmt wird, und andererseits dem Zeitintervall zwischen dem Empfang von zwei aufeinanderfolgenden Synchronisationssignalen, die durch das Strommessmodul empfangen werden, wobei dieses Zeitintervall aus den lokalen Zeitstempeldaten bestimmt wird, geschätzt wird.

5. Verfahren nach einem der vorherigen Ansprüche, wobei jede Spannungsmessung durch das Spannungsmessmodul von dem Spannungsmessmodul mit einem Zeitstempel versehen wird, wobei entsprechende Zeitstempeldaten von dem entsprechenden Spannungsmessmodul für jeden gemessenen Spannungswert gesendet werden.

6. Verfahren nach Anspruch 5, wobei die mit den gemessenen Spannungswerten assoziierten Zeitstempeldaten vor ihrem Senden in der Nachricht automatisch korrigiert werden, indem ein in dem Speicher vorab gespeicherter Zeitkorrekturwert berücksichtigt wird, wobei dieser Zeitkorrekturwert aus einem vorherigen Kalibrierungsverfahren stammt.

7. Verfahren nach einem der Ansprüche 1 bis 5, wobei Zeitstempeldaten, die mit den gemessenen Stromwerten assoziiert sind, automatisch unter Berücksichtigung eines in dem Speicher vorab gespeicherten Zeitkorrekturwerts korrigiert werden, wobei der Zeitkorrekturwert aus einem vorherigen Kalibrierungsverfahren stammt.

8. Verfahren nach Anspruch 6 oder Anspruch 7, wobei zum Berechnen des Zeitkorrekturwerts das Kalibrierungsverfahren ein Verfahren zum Bestimmen einer elektrischen Größe nach einem der vorherigen Ansprüche umfasst.

9. Verfahren nach einem der vorherigen Ansprüche, wobei die Messmodule des Systems über eine drahtlose Kommunikationsverbindung miteinander kommunizieren, wobei jede von dem Spannungsmessmodul gesendete Nachricht eine Funknachricht ist.

10. Verfahren nach einem der Ansprüche 1 bis 8, wobei die Messmodule des Systems über eine drahtgebundene Kommunikationsverbindung, wie beispielsweise ein Datenbus, miteinander in Verbindung sind.

11. Verfahren nach einem der vorherigen Ansprüche, wobei das Berechnen des Werts einer elektrischen Größe durch eine elektronische Verarbeitungsschaltung von mindestens einem der Strommessmodule erfolgt.

12. Verfahren nach einem der vorherigen Ansprüche, wobei der Wert einer berechneten elektrischen Größe eine elektrische Leistung ist, die anhand der von den Messmodulen gemessenen Strom- und Spannungswerte berechnet wird.

13. System (2)
    zum Bestimmen einer elektrischen Größe in einer
    elektrischen Anlage, dieses System umfassend mindestens ein Spannungsmessmodul (4)
    und mindestens
    ein Strommessmodul (6),
    die mit der elektrischen Anlage gekoppelt sind, jedes dieser Messmodule
    umfassend einen Sensor, einen Prozessor, einen Speicher und einen Zeitgeber, wobei das System konfiguriert ist,
    um ein Verfahren zum Bestimmen einer elektrischen Größe zu implementieren, das Verfahren umfassend:

    • durch das Spannungsmessmodul (4):

      ▪ periodisches Messen einer elektrischen Spannung (U) in der elektrischen Anlage,
      ▪ periodisches Senden, an mindestens eines der Strommessmodule, eines Synchronisationssignals
      ▪ Senden, an das Strommessmodul, einer Nachricht, umfassend mindestens ein Haupt-Zeitstempeldatum, das den Zeitpunkt angibt, an dem das Spannungsmessmodul das Synchronisationssignal emittiert hat, wobei dieser Zeitpunkt von dem Spannungsmessmodul mit seiner Uhr gemessen wird,
      ▪ Senden, an das Strommessmodul, einer Nachricht, umfassend mindestens einen gemessenen Spannungswert,

    • durch ein Strommessmodul (6):

      ▪ periodisches Messen eines elektrischen Stroms (I) in der elektrischen Anlage,
      ▪ bei Empfang des von dem Spannungsmessmodul gesendeten Synchronisationssignals, Berechnen, mittels der Zeitgebers des Strommessmoduls, lokaler Zeitstempeldaten, die den Zeitpunkt angeben, an dem das Strommessmodul das Synchronisationssignal empfangen hat,
      ▪ Bestimmen aufeinanderfolgender Verzögerungskorrekturwerte anhand der empfangenen Haupt-Zeitstempeldaten und den lokalen Zeitstempeldaten, die für jedes von dem Spannungsmessmodul empfangene Synchronisationssignal berechnet werden, wobei die von dem Strommessmodul durchgeführten aufeinanderfolgenden Strommessungen von dem Strommessmodul mittels seines Zeitgebers unter Berücksichtigung der somit bestimmten Verzögerungskorrekturwerte mit einem Zeitstempel versehen werden,

    • durch einen Prozessor, Berechnen mindestens eines Werts einer elektrischen Größe anhand der aufeinanderfolgenden Strom- und Spannungswerte, die von den Messmodulen gemessen werden.

**Claims**

1. A method for determining an electrical quantity in an electrical installation, by means of a measurement system (2) comprising at least one voltage measurement module (4) and at least one current measurement module (6) coupled to the electrical installation, each of said measurement modules comprising a sensor, a processor, a memory and a clock, the method comprising:

• by the voltage measurement module (4):

  ▪ periodically measuring an electrical voltage (U) in the electrical installation,
  ▪ periodically sending a synchronisation signal to at least one of the current measurement modules,
  ▪ sending to said current measurement module a message comprising at least one main timestamp data indicating the instant at which the voltage measurement module transmitted the synchronisation signal, this instant being measured by the voltage measurement module with its clock,
  ▪ sending a message comprising at least one measured voltage value to said current measurement module,

• by a current measurement module (6):

  ▪ periodically measuring an electrical current (I) in the electrical installation,
  ▪ on receiving the synchronisation signal sent by the voltage measurement module, calculating, by means of the clock of said current measurement module, a local timestamp data indicating the time at which the current measurement module received said synchronisation signal,
  ▪ determining successive delay correction values from the main timestamp data received and the local timestamp data calculated for each synchronisation signal received from the voltage measurement module, the successive current measurements carried out by the current measurement module being time-stamped by the current measurement module, by means of its clock, taking into account the delay correction values thus determined,

• by a processor, calculating at least one value of an electrical quantity from successive current and voltage values measured by the measurement modules.

2. The method according to claim 1, wherein the delay correction applied to the timestamp data associated with the measured current values is calculated as a function of the difference between the main timestamp data received and the local timestamp data calculated for the same synchronisation signal.

3. The method according to any one of the preceding claims, wherein the calculation of said value of an electrical quantity comprises beforehand an interpolation of the current values for the instants corresponding to the instants for which the voltage values were measured by the voltage measurement module, said interpolation being carried out on the basis of the measured current values and the time-stamp data associated with the measured current values.

4. The method according to any one of the preceding claims, wherein a time drift of the current measurement module is estimated by the ratio between, on the one hand, the time interval between two consecutive transmissions of the synchronisation signal by the voltage measurement module, this time interval being determined from the main time-stamp data, and, on the other hand, the time interval between the reception of two synchronisation signals received consecutively by the current measurement module, this time interval being determined from the local timestamp data.

5. The method according to any one of the preceding claims, wherein each voltage measurement by the voltage measurement module is timestamped by the voltage measurement module, a corresponding timestamp data being sent by the corresponding voltage measurement module, for each voltage value measured.

6. The method according to claim 5, wherein the timestamp data associated with the measured voltage values are automatically corrected, before they are sent in said message, taking into account a time correction value pre-stored in memory, this time correction value coming from a prior calibration method.

7. The method according to any one of claims 1 to 5, wherein timestamp data associated with the measured current values are automatically corrected by taking into account a time correction value pre-stored in memory, this time correction value coming from a prior calibration method.

8. The method according to claim 6 or claim 7, wherein to calculate the time correction value, the calibration method comprises a method for determining an electrical quantity according to any one of the preceding claims.

9. The method according to any one of the preceding claims, wherein the measurement modules of the system are in communication via a wireless communication link, each message sent by the voltage measurement module being a radio message.

17

**10.** The method according to any one of claims 1 to 8, wherein the measurement modules of the system are in communication via a wired communication link, such as a data bus.

**11.** The method according to any one of the preceding claims, wherein the calculation of the value of an electrical quantity is carried out by an electronic circuit for processing at least one of the current measurement modules.

**12.** The method according to any one of the preceding claims, wherein the value of a calculated electrical quantity is an electrical power calculated from the current and voltage values measured by the measurement modules.

**13.** A system (2)
for determining an electrical quantity in an electrical installation,
this system comprising at least one voltage measurement module (4)
and at least
one current measurement module (6)
coupled to the electrical installation, each of said measurement modules comprising a sensor, a processor, a memory and a clock, the system being configured to implement a method for determining an electrical quantity, the method comprising:

    • by the voltage measurement module (4):

        ▪ periodically measuring an electrical voltage (U) in the electrical installation,
        ▪ periodically sending a synchronisation signal to at least one of the current measurement modules
        ▪ sending to said current measurement module a message comprising at least one main timestamp data indicating the instant at which the voltage measurement module transmitted the synchronisation signal, this instant being measured by the voltage measurement module with its clock,
        ▪ sending a message comprising at least one measured voltage value to said current measurement module,

    • by a current measurement module (6):

        ▪ periodically measuring an electrical current (I) in the electrical installation,
        ▪ on receiving the synchronisation signal sent by the voltage measurement module, calculating, by means of the clock of said current measurement module, a local timestamp data indicating the time at which the current measurement module received said synchronisation signal,
        ▪ determining successive delay correction values from the main timestamp data received and the local timestamp data calculated for each synchronisation signal received from the voltage measurement module, the successive current measurements carried out by the current measurement module being timestamped by the current measurement module, by means of its clock, taking into account the delay correction values thus determined,

    • by a processor, calculating at least one value of an electrical quantity from successive current and voltage values measured by the measurement modules.

FIG.1

EP 4 198 526 B1

FIG.2

FIG.3

FIG.4

FIG.5

EP 4 198 526 B1

FIG.6

EP 4 198 526 B1

**EP 4 198 526 B1**

## RÉFÉRENCES CITÉES DANS LA DESCRIPTION

**Documents brevets cités dans la description**

- EP 3761046 A1
- US 2021356501 A1
- US 201708379 A1